# EUROPEAN PATENT APPLICATION

(11) **EP 1 127 957 A1**
(43) Date of publication of application: **29.08.2001**
(21) Application number: 00311790.0
(22) Date of filing: 29.12.2000
(51) Int. Cl.: C23C 16/44

(54) **A film forming apparatus having cleaning function**

(30) Priority: 24.02.2000 US 511934
(71) Applicant: ASM JAPAN K.K., Tama-shi, Tokyo 206-0025 (JP)
(72) Inventor: Fukuda, Hideaki, Tama-shi, Tokyo 206-0025 (JP); Satoh, Kiyoshi, Tama-shi, Tokyo 206-0025 (JP)
(74) Representative: Bucks, Teresa Anne

(57) **Abstract**

A thin-film forming apparatus includes: (a) a reaction chamber (2) for forming a thin film on a workpiece (9) placed on a susceptor (3) provided in the reaction chamber; and (b) a cleaning device (30) for cleaning unwanted deposits adhering to the inside of the reaction chamber at predetermined intervals. The cleaning device includes: (i) a cleaning gas controller (15,21) for introducing a cleaning gas into the reaction chamber and evacuating the reaction chamber after the cleaning treatment; (ii) a cleaning gas activator (16) for activating the cleaning gas in radical form; and (iii) a temperature and timing controller programmed to reduce the temperature of the susceptor at a predetermined rate for cleaning after completion of film formation and then to actuate the cleaning gas controller and the cleaning gas activator.

## Description

### Background of the Invention

### Field of the Invention

The invention relates to a thin-film forming apparatus that is used in a process for semiconductor device circuit manufacturing, and particularly to a thin-film forming apparatus having an automatic cleaning function, and an automatic cleaning method of a thin-film forming apparatus.

### Description of the Related Art

In the process of forming a film on a semiconductor substrate, the semiconductor substrate, i.e., workpiece is placed on a resistance type of heater that functions as a susceptor provided in an evacuated reaction chamber. After a showerhead having holes for expelling reaction gas is opposed to the heater, radiofrequency energy at 13.56 MHz is applied to the showerhead, by which a plasma discharge region is formed between the heater supporting the semiconductor substrate and the showerhead. Reaction gas supplied by the showerhead is excited and activated in the plasma discharge region, and a film is formed, depending on the kinds of reaction gas, on the semiconductor substrate. At this time, films and reaction by-products adhere to the inside surface of the reaction chamber in addition to the semiconductor substrate.

With repeated film formation processes, unwanted deposits adhering to portions other than the semiconductor substrate accumulate. After separating from the attached surface the unwanted deposits become particles and stick to the surface of the semiconductor substrate, causing impurity contamination, stopping functions of semiconductor devices. To eliminate unwanted deposits from the reaction chamber, many thin film-forming apparatuses may have an automatic cleaning function.

The automatic cleaning function cleans the reaction chamber using a fluorine-containing active species, after detaching the semiconductor substrate on which film formation is complete, from the heater and conveying it outside of the reaction chamber. Specifically, when forming a silicon nitride film on the semiconductor substrate, a mixture gas of SiH₄, NH₃ and N₂ is furnished to the reaction chamber as a reaction gas to produce a plasma discharge region in the reaction chamber using radiofrequency energy.

The unwanted deposits, which mainly comprises the same material as the film deposited on a semiconductor substrate, also adhere to the inner surface of the reaction chamber. After the finished semiconductor substrate is conveyed outside of the reaction chamber, C₂F₆ and oxygen or a mixture gas of C₃F₈ and oxygen are supplied to the reaction chamber from the showerhead. Then fluorine active species is generated in the reaction chamber by applying radiofrequency energy of 13.56 MHz. The unwanted deposits inside of the reaction chamber are gasified by the fluorine active species and exhausted from the reaction chamber. Automatic cleaning sequence after performing film formation once or more than once on the semiconductor substrate always keeps clean the inside of the reaction chamber.

Film-forming requirements of a silicon nitride film and an silicon oxinitride film (silicon nitride type of film) by a capacitance coupling plasma CVD method are conventionally that a gas flow ratio of a SiH₄: N₂: NH₃ system is approximately SiH₄: N₂: NH₃= 1: 1-50: 1-10, and that the temperature for a workpiece is approximately below 400°C. Both requirements are used industrially for insulating films of a semiconductor device. Some examples of the film-forming requirements are disclosed in U.S. Patent No. 5,336,640. Since the films incorporate hydrogen, when a step having a higher temperature than the film-forming temperature follows, the hydrogen incorporated in the films is released, which remarkably worsens electrical characteristics of the semiconductor device. Therefore, a main application is a final passivation film for the semiconductor device which does not have the step of higher temperature processing (the example disclosed in U.S. Patent 5,336,640 is the one used as a final protection film).

To solve a problem of an increase in RC delay (which is proportional to the product of metal line resistance and capacitance between lines) in the wiring accompanied by increased density of semiconductor devices, there are proposals that resistance should be lowered by the introduction of Cu wiring, and that distribution line capacitance should be reduced. In the semiconductor device having Cu wiring, because the Cu wiring is high in heat resistance, a SiOF film formed by relatively high temperature plasma CVD can be used as an insulating film disposed between the metal lines.

When applying Cu wiring, a damascene step is generally conducted in which ditch patterns of metal lines in an insulating film between layers are formed and Cu wiring is embedded in the ditches. To form the ditches in an insulating film between layers, hetero-etching by reactive ion etching (RIE) can be used. A silicon nitride type of film formed by plasma CVD may be used as a RIE etching-stopping layer. A silicon nitride type of film formed by plasma CVD may be used as an antireflective film to prevent the reflection of exposed light in the lower part of a resist at a lithography step so as to accurately perform a fine-structure processing.

In the above situations, a processing temperature of approximately 400°C has increased to exceed 500°C. When the substrate is heated to over 500°C and film-forming on the semiconductor substrate is executed, unwanted deposits adhere to the inside of the reaction chamber. Since the attached unwanted deposits are a source of particles and contamination, they are removed by executing the automatic cleaning sequence as previously mentioned. In the process of forming a silicon nitride film, gas including fluorine is used for automatic cleaning. At the plasma discharge region in the reaction chamber or at the excitation chamber isolated from the reaction chamber, a fluorine active species is generated which is used to remove the unwanted deposits in the reaction chamber. In order to form a film on the semiconductor substrate, the surface of the ceramic heater supporting the substrate is set at a predetermined temperature range for film formation. When the semiconductor substrate on which film formation is complete is conveyed out of the reaction chamber, the automatic cleaning sequence follows immediately. That is, parts in the reaction chamber, especially a ceramic heater which holds directly and heats a semiconductor substrate, is in a state so-called "film-forming temperature" at which high temperature it is exposed to the environment of automatic cleaning. However, the above conventional cleaning treatment causes problems as described below.

### Summary of the Invention

In order to form a film on the semiconductor substrate, the surface of the ceramic heater supporting the substrate is set at a predetermined temperature range of 470-600°C. In the temperature environment in excess of 470°C, even aluminum nitride reacts with the fluorine active species to generate aluminum fluoride, which in turn emits the aluminum fluoride generated to the reaction chamber. When the surface temperature of the heater exceeds 500°C, generation and emission of aluminum fluoride causes extensive damage to the reaction chamber. The temperature of the surface of a showerhead opposed to the ceramic heater supporting the semiconductor substrate is 100-250°C which is lower than that of the ceramic heater. Aluminum fluoride emitted from the ceramic heater adheres to the showerhead of relatively lower temperature, and accumulates due to the reaction with fluorine active species during the automatic cleaning sequence. The aluminum fluoride once stuck to the showerhead cannot be removed except for wiping off with the reaction chamber open.

An objective of the present invention is to provide an automatic cleaning method which does not produce aluminum fluoride on a showerhead.

Another objective of the present invention is to realize forming a film with good reproducibility and without foreign contamination (particles) by an automatic cleaning sequence.

Yet another objective of the present invention is to provide a thin-film forming apparatus which reduces non-working hours for cleaning and enhances productivity by use of an automatic cleaning sequence.

Namely, an embodiment of the present invention A thin-film forming apparatus comprising: (a) a reaction chamber for forming a thin film on a workpiece placed on a susceptor provided in the reaction chamber, which susceptor is provided with a heater for heating the workpiece, which reaction chamber is provided with a conveyer for loading and unloading the workpiece into and from the reaction chamber; and (b) a cleaning device for cleaning unwanted deposits adhering to the inside of the reaction chamber at predetermined intervals, which cleaning device comprises: (i) a cleaning gas controller for introducing a cleaning gas into the reaction chamber and evacuating the reaction chamber after the cleaning treatment; (ii) a cleaning gas activator for activating the cleaning gas in radical form; and (iii) a temperature and timing controller programmed to reduce the temperature of the susceptor at a predetermined rate for cleaning after completion of film formation and then to actuate the cleaning gas controller and the cleaning gas activator.

In the above, the temperature of the susceptor for cleaning is preferably 500°C or less, more preferably 470°C or less, while the temperature of the susceptor for film formation may be higher than 500°C. In an embodiment, the cleaning gas includes fluorine, and the activated cleaning gas includes fluorine radicals. Among others, the cleaning gas can be activated using a plasma discharge region generated in the reaction chamber or using a remote plasma discharge chamber prior to introduction of the cleaning gas into the reaction chamber. Further, the cleaning gas controller can introduce the cleaning gas through a showerhead disposed above the susceptor in the reaction chamber.

In an embodiment, the unwanted deposits include silicon nitride, SiO, SiON, SiOF, SiC, and hydrocarbon. The apparatus includes a plasma CVD apparatus and a thermal CVD apparatus.

The present invention can also apply to a method for cleaning unwanted deposits adhering to the inside of a reaction chamber for forming a thin film on a workpiece placed on a susceptor provided in the reaction chamber, said susceptor being provided with a heater for heating the workpiece, said reaction chamber being provided with a conveyer for loading and unloading the workpiece into and from the reaction chamber, said method comprising: (a) reducing the temperature of the susceptor at a predetermined rate for cleaning after completion of film formation; (b) contacting the inside of the reaction chamber with an activated cleaning gas; and (c) cleaning the unwanted deposits by the activated cleaning gas.

### Brief Description of the Drawings

FIG. 1 shows one example of a thin film-forming and processing apparatus according to the present invention.

FIG. 2 illustrates a thin film-forming and processing apparatus having a remote plasma discharge chamber.

FIG. 3 illustrates the measurement results of the thickness of formed silicon nitride films.

FIG. 4 illustrates the distribution lines of the thickness of formed silicon nitride films on one semiconductor substrate 9.

FIG. 5 illustrates the measurement results of particles on the surface of semiconductor substrates after the formation of silicon nitride films.

### Detailed Description of the Preferred Embodiment

### Applicable Thin-Film Forming Apparatus

When a conventional silicon nitride film formed by plasma CVD in the semiconductor device is used, a problem arises. That is, after forming a silicon nitride type of film having a high hydrogen concentration which has been used as a final protection film in the past, when forming a SiOF film formed by relatively high temperature plasma CVD on the silicon nitride type of film, hydrogen in the SiOF film is dissociated during formation and coherence of the film is reduced, causing separation of the film. The reason is that the film-forming temperature is 470°C, which is relatively high. When separation of the film has occurred, yield of the workpiece will, as a whole, drop because a semiconductor device including separated portions causes short circuits in distribution lines and poor conduction.

A silicon nitride type of film formed by thermal CVD over 700°C without plasma may not be used as an inter-layers insulating film, because the film-forming temperature is too high after formation of Al or Cu. Since almost no hydrogen is included in the film, the silicon nitride type of film has been used as an etching stopping layer for a first between-layers insulating film on the semiconductor device to which a thermal step is applied later.

However, because semiconductor devices have become highly minute in recent years, accordingly, gate length has become smaller and it is now below 0.18 µm. Therefore it is difficult to prevent formation and diffusion of impurity layers due to the thermal load when in high temperature thermal steps of over 700°C. In the case of insufficient control of diffused layers, reliance on semiconductor devices will be reduced since there is produced dispersion in operating voltage. Thus, desired is a film-forming method requiring a low thermal load for semiconductor devices which enables film-forming at a lower temperature than that of high temperature thermal CVD, the film being a silicon nitride type of film having a low density of hydrogen.

To this end, the inventors have invented a method of forming a silicon nitride film using plasma CVD at a relatively higher temperature which is described in Japanese Patent Application No. 11-243914. By raising a semiconductor substrate temperature of approximately 400°C in the past to a range of 430-600°C, a silicon nitride film having a low density of hydrogen can be formed. The semiconductor substrate temperature is preferably over 470°C and more preferably over 550-600°C.

To set a semiconductor substrate temperature at 470-600°C, the surface of a heater (which supports the semiconductor substrate) for heating the substrate requires raising the temperature to 500-650°C, which is beyond the heat resistance of a metallic heater where a sheath heater is buried in conventional aluminum alloy. Accordingly, a ceramic heater is used so that high temperatures can be attained. As a ceramic material, aluminum nitride with high heat conductivity may generally be used. A ceramic heater comprising a aluminum nitride disk or plate has a resistance heater and a metal for a plasma-discharge ground electrode embedded by integral sintering, which allows the semiconductor substrate to be heated to approximately 650°C.

### Analysis of Conventional Cleaning System

When the substrate is heated to over 470°C using the ceramic heater and film-forming on the semiconductor substrate is executed, unwanted deposits adhere to the inside of the reaction chamber. Since the attached unwanted deposits are a source of particles and contamination, they are removed by executing the automatic cleaning sequence as previously mentioned. In the process of forming a silicon nitride film, gas including fluorine is used for automatic cleaning. At the plasma discharge region in the reaction chamber or at the excitation chamber remote from the reaction chamber, a fluorine active species is generated which is used to remove the unwanted deposits in the reaction chamber

In order to form a film on the semiconductor substrate, the surface of the ceramic heater supporting the substrate is set at a predetermined temperature range of 470-600°C. When the semiconductor substrate on which film formation is complete is conveyed out of the reaction chamber, the automatic cleaning sequence follows immediately. That is, one of the parts in the reaction chamber, especially a ceramic heater which holds directly and heats a semiconductor substrate, is in a state so-called "film-forming temperature" at which high temperature it is exposed to the environment of automatic cleaning. In the temperature environment in excess of 470°C, even aluminum nitride reacts with the fluorine active species to generate aluminum fluoride, which in turn emits the aluminum fluoride generated to the reaction chamber.

When the surface temperature of the heater exceeds 500°C, generation and emission of aluminum fluoride causes extensive damage to the reaction chamber. The temperature of the surface of a showerhead opposed to the ceramic heater supporting the semiconductor substrate is 100-250°C which is lower than that of the ceramic heater. Aluminum fluoride emitted from the ceramic heater adheres to the showerhead of relatively lower temperature, and accumulates due to the reaction with fluorine active species during the automatic cleaning sequence. The aluminum fluoride once stuck to the showerhead cannot be removed except for wiping off with the reaction chamber open.

The accretion of aluminum fluoride to the surface of the showerhead causes two substantial problems. One problem is that growth speed of a film to be formed on the semiconductor substrate varies. When non-conductive aluminum fluoride adheres to the surface of the showerhead, the non-conductive aluminum fluoride functions as a newly formed electric insulator formed on the surface of the showerhead, thereby reducing a film-forming speed. The difference in accretion of aluminum fluoride (thickness) at the surface of the single showerhead produces abnormal distribution lines in formed film thickness on the surface of a semiconductor substrate. The degree of variability of no more than ±3 % is required regarding film thickness (value defined by subtracting the minimum thickness from the maximum thickness and dividing it by 2 times the average).

Differences in film thickness formed on the semiconductor substrate leads to non-uniformity of semiconductor device functions of the semiconductor substrate. In the case where film thickness cannot be attained as designed, the semiconductor devices do not function properly and are judged to be inferior. Attachment of aluminum fluoride to the entire surface of the showerhead gives rise to insufficient thickness of the entire film on the semiconductor substrate. Repeated film formation on the semiconductor substrate gradually reduces film thickness which should otherwise increase. According to present technological standards, reproducibility of film thickness on the semiconductor substrate should be less than approximately ±3 %. When film thickness grown on the semiconductor substrate varies beyond this value, all the semiconductor devices on the semiconductor substrate are inferior.

The second problem is contamination of the semiconductor substrate by particles. If aluminum fluoride accretes to and accumulates on the surface of the showerhead, particles of the aluminum fluoride will slough off the surface and adhere to the surface of the semiconductor substrate. The aluminum fluoride deposited on the semiconductor substrate cause contamination or defect at the bottom, middle or surface of a film to be formed on the semiconductor substrate, which causes malfunctions of the semiconductor device. Generally speaking, the number of particles attached on the semiconductor substrate should not exceed 20 with a diameter of over 0.2 µ m.

In addition, in order to eliminate problems caused by aluminum fluoride, as mentioned before, there is no other way than to physically remove aluminum fluoride accreted to the surface of the showerhead; film-forming and processing is interrupted, the reaction chamber is opened, and wipe-off cleaning must be done manually. Because the wipe-off cleaning is performed while film-forming and processing by a thin-film forming apparatus are stopped, operating efficiency and productivity of the apparatus are remarkably decreased.

### Film-Formation and Processing Prior to Cleaning

In an embodiment, there is provided a first semiconductor substrate as a workpiece for film-forming and processing, on a heater with a surface temperature of over 500°C placed in a reaction chamber of a thin-film forming apparatus. Reaction gas is furnished from a showerhead to which is applied radiofrequency energy of 13.56 MHz. At a plasma discharge region generated between the showerhead and the heater supporting the semiconductor substrate, the reaction gas is dissolved and a thin film is formed on the semiconductor substrate. The first semiconductor substrate, on which film formation is complete, is removed from the heater and conveyed out of the reaction chamber. A second semiconductor substrate for film-forming and processing is carried into the reaction chamber and is placed on the heater. The same film-forming and processing steps are conducted as with the first semiconductor substrate. The second semiconductor substrate is removed from the reaction chamber after film-forming and processing is complete.

When conducting a series of film-forming and processing processes (film sequence) of #1 to #n semiconductor substrates, after removing the #n semiconductor substrate from the reaction chamber, a cleaning sequence follows which cleans unwanted deposits adhering to the inside of the reaction chamber.

### Subsequent Cleaning Sequence

The cleaning sequence includes a cooling step which lowers the temperature of the heater supporting and heating the semiconductor substrate. When the #n semiconductor substrate is removed from the reaction chamber and automatic cleaning for the reaction chamber gets ready to operate, nitrogen gas is introduced into the reaction chamber to obtain an arbitrary pressure and the temperature of the ceramic heater is lowered at a rate not exceeding 20°C per minute.

When the surface temperature of the ceramic heater is below 500°C, cleaning gas is injected into the reaction chamber to conduct automatic cleaning in the reaction chamber and unwanted deposits adhering to the inside of the reaction chamber will be gasified and exhausted. The cleaning step which removes the products from the reaction chamber can be performed substantially in the following way, although the step should not be limited thereto:

### In-Situ Plasma Cleaning

In an embodiment, a mixture gas of C₃F₈ gas and oxygen gas controlled at a predetermined flow is introduced, as a cleaning gas, into the reaction chamber from the shower head. Maintaining the inside of the reaction chamber at a predetermined pressure, radiofrequency energy of 13.56 MHz, for example, is applied to the showerhead to form a plasma discharge region between the showerhead and the ceramic heater. The cleaning gas introduced from the showerhead is activated by the plasma discharge to become a fluorine-containing active species which reacts with the unwanted deposits adhering to the inside of the reaction chamber and transforming into gas material to be evacuated from the reaction chamber by an evacuation pump. During the cleaning step, the surface temperature of the ceramic heater is kept at below 500°C.

The cleaning step is terminated when radiofrequency energy applied to the showerhead and C3F8 gas is terminated. The oxygen gas supplied to the reaction chamber as part of the cleaning gas is injected into the reaction chamber after the completion of the cleaning step. The fluorine active species produced during the cleaning step and the reaction products produced by the reaction between the fluorine active species and the unwanted deposits in the reaction chamber are purged from the reaction chamber. After evacuating the reaction chamber, a heating step follows that raises the temperature of the ceramic heater to the temperature for film-forming and processing of the semiconductor substrate. When the ceramic heater temperature reaches a predetermined temperature, the automatic cleaning sequence is complete. When the automatic cleaning sequence is finished, the #(n+1) semiconductor substrate is brought in the reaction chamber to be placed on the ceramic heater. Then the aforementioned thin film-forming and processing of the semiconductor substrate (film-forming sequence) is conducted.

### Remote Plasma Cleaning

The aforementioned cleaning step can be done in another way including the following: The cleaning gas is activated in a remote plasma discharge chamber remote from the reaction chamber where thin film formation on the semiconductor substrate is performed. The activated cleaning gas is introduced via a duct into the reaction chamber where thin-film forming and processing to the semiconductor substrate is executed. The activated cleaning gas, introduced into the reaction chamber, transforms the unwanted deposits adhering to the inside of the reaction chamber into gaseous material which is expelled from the reaction chamber.

When thin film-forming and processing of a predetermined number of semiconductor substrates is complete and when the automatic cleaning sequence in the reaction chamber is complete, the cooling step is conducted which reduces the temperature of the heater supporting the semiconductor substrate to below 500°C. When the cooling step is complete, argon gas controlled at a predetermined flow rate is furnished in the remote plasma discharge chamber. After radiofrequency discharge of 400 kHz is generated in the remote plasma discharge chamber, a cleaning gas including fluorine such as NF₃ controlled at a predetermined flow rate is introduced to generate a fluorine active species. The fluorine active species is introduced into the reaction chamber via the remote plasma discharge chamber and the duct which connects the reaction chamber for film formation. The inside of the reaction chamber is cleaned by the fluorine active species, the heating step is performed as previously described wherein the heater temperature in the reaction chamber is raised to the thin film formation temperature.

The first automatic cleaning sequence mentioned is called in-situ plasma cleaning, in which, to activate cleaning gas, a discharge electrode in the reaction chamber used at the time of film formation and a radiofrequency energy supply are employed. The second automatic cleaning sequence mentioned is called remote plasma cleaning, in which, to activate cleaning gas, the remote plasma discharge chamber placed away from the reaction chamber is used, but not the radiofrequency energy supply for film formation.

### EXAMPLE 1

### Structures of Apparatus (In-Situ Plasma Cleaning)

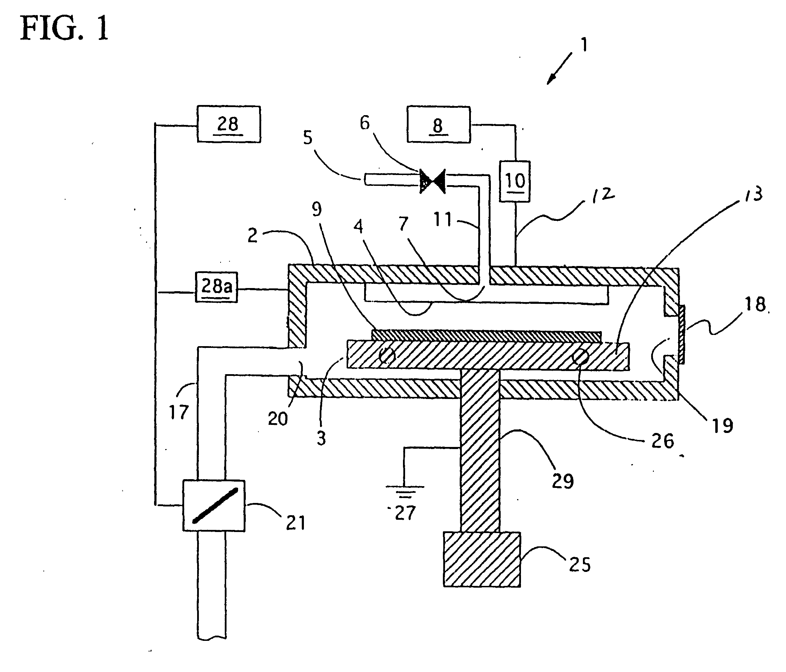

FIG. 1 shows one example of a thin film-forming and processing apparatus 1 according to the present invention, in which a parallel plate plasma CVD apparatus and an in-situ plasma cleaning apparatus for automatic cleaning are used.

A workpiece 9 to be processed such as a semiconductor substrate is placed on a ceramic heater 3 to hold the workpiece in a reaction chamber 2. Opposed to the heater 3 is placed a showerhead 4 which provides uniform reaction gas on the workpiece 9. Reaction gas for forming a film on the surface of the workpiece 9 is controlled at a predetermined flow by a mass flow controller (not shown), and enters a duct 5 to a duct 11 through a valve 6. After passing through an aperture 7 of the reaction chamber 2, the gas is provided within the reaction chamber 2 through thousands of tiny holes, with a diameter of less than 1 mm, of the showerhead 4.

To evacuate the reaction chamber 2, an evacuation pump (not shown) is connected to an aperture 20 of the reaction chamber 2 via a duct 17 and a conductance controlling valve 21. The heater 3 for holding the workpiece 9 includes an aluminum nitride plate 13 with a resistance heating element 26 embedded, and is connected to the reaction chamber 2 by a shaft 29.

### Film-Formation Process

A method of forming a film on the workpiece 9 will be explained below. When a silicon nitride film is formed on the workpiece 9, gases of SiH4, NH3 and N2, or SiH4 and NH3, or SiH4 and N2 are used as a reaction gas, and radiofrequency energy of 13.56 MHz, or power of a mixture of 13.56 MHz and 430 kHz is applied to the showerhead 4. The workpiece 9 receives heat from the heater with 600°C to have a temperature in the range of approximately 530°C-550°C. Reaction gases such as SiH4 and N2, etc. are introduced into the duct 11 through the valve 6 from the duct 5, and are uniformly supplied to the inside of the reaction chamber 2 through the shower head 4 from the aperture 7 of the duct 11. While introducing the reaction gases into the reaction chamber 2 at a predetermined flow rate, the pressure of the reaction chamber 2 is adjusted in a range of 1 Torr to 8 Torr in response to a signal at a pressure meter 28a via the opening of a conductance controlling valve 21 controlled by a pressure controller 28.

As mentioned above, while maintaining the temperature, gas flow and pressure controlled at predetermined values, a predetermined radiofrequency energy is applied between the electrodes to generate plasma, which in turn forms a silicon nitride film on the workpiece 9. By controlling the duration of time that the radiofrequency energy is applied, a silicon nitride film with a necessary thickness may be obtained. After completing formation of the film on the workpiece 9, the workpiece 9 is conveyed outside of the reaction chamber 2 by an automatic conveyer (not shown) when a gate valve 18 of a reaction chamber opening 19 is opened.

### In-Situ Plasma Cleaning Sequence

The unwanted deposits adhering to the inside of the reaction chamber 2 in forming the film on the workpiece are removed in an automatic cleaning sequence. The automatic cleaning sequence comprises the steps of: cooling, which cools the temperature of the heater 3 supporting the workpiece 9 to below 500°C; cleaning, which cleans the inside of the reaction chamber 2; and heating, which raises the temperature of the heater 3 to 600°C for film formation.

In the cooling step, introducing nitrogen gas at 2 liters per minute (2slm) in the reaction chamber 2, the pressure can be within a range of 0.5-9 Torr, and the temperature of the heater 3 can be lowered at a rate of not over 20°C per minute. The flow of nitrogen gas is not limited to 2 liters per minute. The gas to be introduced is not limited to nitrogen; instead, inert gas, such as helium, argon, etc. which do not damage the ceramic heater 3, the reaction chamber 2, and the articles inside, may be used. The temperature lowering rate of the heater 3 is not limited to under 20°C per minute; any rate which does not cause damage to the heater 3 may be used. When the temperature of the heater 3 is below 500°C, the cooling step is complete. Preferably, it should be below 450°C. The temperature of the heater 3 is defined by that on the surface of the ceramic heater which touches the back side of the semiconductor substrate 9.

The cleaning step is conducted in the following way. A mixture of C3F8 with 300 sccm and oxygen with 700 sccm is introduced as a cleaning gas to the inside of the reaction chamber 2 from the showerhead 4. With the pressure in the reaction chamber 2 within a range of 2-5 Torr, 13.56 MHz of radiofrequency energy of 500 w-2,000 w is applied to the showerhead 4 to cause a plasma discharge region between the showerhead 4 and the ceramic heater 3. The cleaning gas is activated by the plasma, which generates a fluorine-containing active species. The fluorine active species reacts with the unwanted deposits adhering to the inside of the reaction chamber 2 and eventually convert them into a gas. The gas is evacuated from the reaction chamber 2 through the aperture 20 by an evacuation pump (not shown). The temperature of the ceramic heater 3 during the cleaning steps is kept below 500°C.

Upon completion of the cleaning of the reaction chamber 2, the supply of radiofrequency energy to the showerhead 4 is stopped and the supply of C₃F₈ gas to the reaction chamber 2 is stopped . The inside of the reaction chamber 2 is purged by oxygen gas. By stopping the supply of oxygen gas and instead supplying nitrogen gas, the reaction chamber 2 may be purged.

A subsequent heating step raises the temperature of the heater 3 to the film formation temperature. Nitrogen gas is supplied to the reaction chamber 2 through the showerhead 4 at a rate of 2 liters per minute (2slm), which holds the pressure of the reaction chamber 2 in a range of 0.5-9 Torr and raises the temperature of the heater 3 at a rate not exceeding 20°C per minute. Gas supplied to the reaction chamber 2 is not limited to nitrogen gas; any gas is usable as long as it does not damage parts including the heater 3 in the reaction chamber 2. The flow of gas including nitrogen gas is not limited to 2 liters per minute (2slm); any flow may be acceptable which can keep the pressure of the reaction chamber 2.

In addition, the rate of the increase in temperature of the heater 3 is not limited to under 20°C per minute; the temperature of the heater 3 can be raised at a rate which does not damage the heater 3. When the temperature of the heater 3 has reached the film-forming temperature, the heating step is complete. Completion of the heating step completes the automatic cleaning sequence. The next workpiece is brought in, and the thin-film forming process is conducted.

In the cooling and heating steps for changing the temperature of the heater 3, the rate of change is not limited to under 20°C per minute. As long as the heater 3 is not damaged by the temperature change, the faster the temperature change, the shorter the automatic cleaning sequence, which enhances productivity of the thin-film forming apparatus.

### EXAMPLE 2

### Structures of Apparatus (Remote Plasma Cleaning)

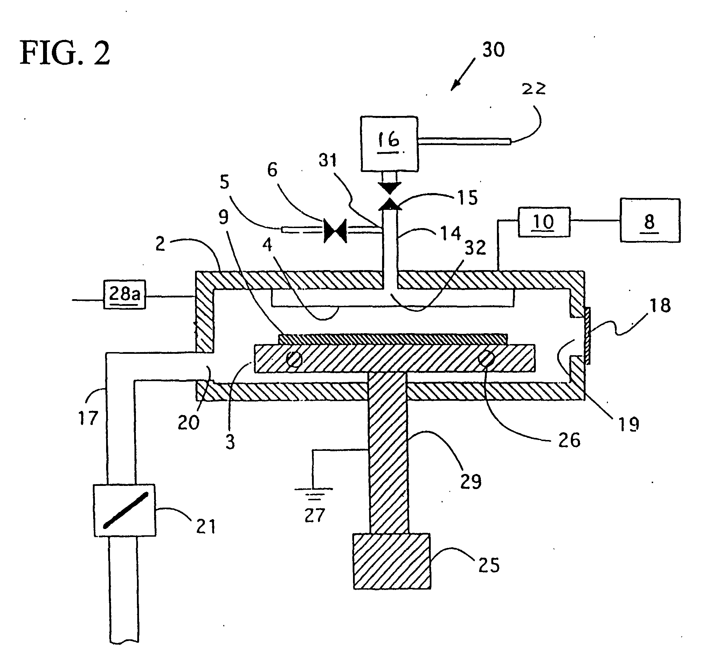

FIG. 2 illustrates an example of a thin film-forming and processing apparatus 30 having a remote plasma discharge chamber, and is the same as a thin film-forming and processing apparatus of FIG. 1 except for the structure by which unwanted deposits adhering to the inside of the reaction chamber 2 are automatically removed.

In the upper portion of the reaction chamber 2 are provided a duct 5 and a valve 6 which supply reaction gas to the reaction chamber 2 for thin film-forming and processing. The reaction gas is uniformly supplied onto the surface of a workpiece 9 through a showerhead 4 having thousands of fine holes with a diameter of less than 1 mm via a duct 14 and an opening 32 of the reaction chamber 2. When conducting thin film-forming and processing of the workpiece 9, a valve 15 is closed which valve is provided on the duct 14 connecting a remote plasma discharge chamber 16 to the reaction chamber 2.

### Remote Plasma Cleaning Sequence

After at least one of the thin film-forming and processing steps to the workpiece 9 in the reaction chamber 2 is complete, an automatic cleaning sequence is done which cleans unwanted deposits deposited on the inside of the reaction chamber 2. The automatic cleaning sequence is, as mentioned before, comprised of three steps of: cooling, cleaning and heating up. The cooling step supplies nitrogen gas at 2 liters per minute to the reaction chamber 2 from the duct 5 via the valve 6, junction 31, duct 14, opening 32 and showerhead 4, and lowers the temperature of the heater 3 at a rate not exceeding 20°C per minute, keeping the pressure of the reaction chamber 2 within a range of 0.5-9 Torr.

Subsequently performed is the cleaning step which removes the unwanted deposits deposited on the inside of the reaction chamber 2. The step is done in the following way. The supply of nitrogen gas, which is complete during the cooling down step, is suspended, and after the reaction chamber is evacuated, argon gas is injected from the duct 22 into the remote plasma discharge chamber 16 at a flow of 3 liters per minute (3 slm). At that time, with the valve 15 open and the valve 6 closed, argon gas brought in from the duct 22 is conveyed to the reaction chamber 2 through the remote plasma discharge chamber 16.

Holding the pressure of the reaction chamber 2 in a range of 0.05-8 Torr, radiofrequency discharge of 400kHz is generated in the remote plasma discharge chamber 16. The flow of argon is gradually changed to 2 liters per minute, and NF3 gas is injected from the duct 22, which is gradually raised from zero to 1 slm by a mass flow controller (not shown). The gas supplied to the remote plasma discharge chamber 16 is changed simply by gradually increasing an amount of NF₃. The gas (cleaning gas) supplied to the remote plasma discharge chamber 16 in a stable state consists of 2 liters of argon per minute and 1 liter of NF3 per minute. Radiofrequency discharge plasma generated in the remote plasma discharge chamber 16 produces a fluorine active species. The cleaning gas including the fluorine active species is injected to the showerhead 4 from the upper opening 32 of the reaction chamber 2 through the valve 15 and duct 14. The cleaning gas, which is introduced into the reaction chamber 2 through thousands of small holes provided on the shower head 4, transforms into gas the unwanted deposits deposited on the inside of the reaction chamber 2 and evacuates them from the reaction chamber 2. During the cleaning step, the temperature of the heater 3 should be held at least below 500°C.

The flow rate of the cleaning gas injected into the remote plasma discharge chamber 16 during the cleaning step is not limited to the previously described flow rate, and may be selected from the range of 100 sccm to 5 slm regarding NF₃ and from the range of 100 sccm to 5 slm regarding argon. As cleaning gas, instead of argon gas, rare gas such as helium may be used. Instead of NF₃, CF gas such as C₃F₈ may be used. At that time, in addition to, or instead of, argon gas, oxygen gas can be mixed.

During the cleaning step, the temperature of the heater is kept below 500°C, preferably below 470°C, and more preferably below 450°C. Power frequency supplied to the remote plasma discharge chamber 16 is not limited to 400 kHz, and may be selected from 300-500 kHz. The value of the power must be one by which a predetermined fluorine active species can be obtained. In the embodiment of the invention, power of 2,000-5,000 W at 400 kHz is used to generate radiofrequency discharge plasma in the remote plasma discharge chamber 16.

After the unwanted deposits adhering to the inside of the reaction chamber 2 are completely removed from the inside of the reaction chamber 2 by the cleaning gas with the fluorine active species, the supply of NF3 gas injected from the duct 22 is suspended and the radiofrequency discharge in the remote plasma discharge chamber 16 is stopped. Even after the suspension of the supply of NF3 gas and the radiofrequency discharge, argon gas is furnished to the reaction chamber 2 from the duct 22 via the remote plasma discharge chamber 16, which purges the cleaning gas with the fluorine active species remaining in the reaction chamber 2. The heating step begins, which commences purging in the reaction chamber 2 by argon gas and raises the temperature of the heater 3 to the film-forming temperature. The heat-up step is executed the same way as the aforementioned cooling step except for raising the temperature of the heater 3 at a speed of less than 20°C per minute. When the temperature of the heater 3 reaches the temperature (the film-forming temperature) at which thin film-forming and processing of the workpiece 9 is conducted, the heating step is complete.

While cooling and heating are being conducted, introduction of nitrogen gas into the reaction chamber 2 may also performed in the following alternative way. A predetermined flow of nitrogen gas is furnished to the duct 22 and injected to the reaction chamber 2 via the remote plasma discharge chamber 16, valve 15, and duct 14. At this time, the valve 6 is closed and plasma discharge in the remote plasma discharge chamber 16 is not performed. Via the remote plasma discharge chamber 16 from the duct 22, injection of argon gas into the reaction chamber 2, and the cooling and heating steps can also be executed.

### Cleaning Results

Embodiments in accordance with the invention will be explained. The result when a silicon nitride film was formed on the semiconductor at the film-forming temperature 600°C will be described below. The apparatus used was the thin film-forming and processing apparatus 30 in FIG. 2. The first semiconductor substrate 9, the workpiece, comprising aluminum nitride substrate, was placed on the ceramic heater 3. The ceramic heater 3 was held at 600°C because of the resistance heater 26 embedded, which heated the first semiconductor substrate 9 supported on the ceramic heater 3 to 550°C from approximately 540°C. SiH4 gas and nitrogen were mixed and introduced from the duct 5. The mixed gas was uniformly distributed, by the showerhead 4, on the surface of the first semiconductor substrate 9 placed on the heater 3 in the reaction chamber 2.

400 W radiofrequency energy of 13.56 MHz were applied to the showerhead 4, and a plasma region was formed between the showerhead 4 and the heater supporting the first semiconductor substrate 9. A silicon nitride film of 100 nm was then formed on the surface of the first semiconductor substrate 9. After opening the gate 18 and removing the first semiconductor substrate 9, on which a silicon nitride film was formed, through the aperture 19 of the reaction chamber 2, a second semiconductor substrate 9 was introduced into the reaction chamber 2 by the same route as above and was placed on the heater 3 to form a silicon nitride film.

As with the previous film-formation and processing of the silicon nitride film, the silicon nitride film is formed on the second semiconductor substrate 9. In this way, the film-formation and processing of the silicon nitride film was consecutively performed on 25 substrates. After the 25th substrate that had completed the film-formation and processing was removed from the reaction chamber 2, the automatic cleaning sequence was executed that cleans the unwanted deposits adhering to the inside of the reaction chamber 2.

In the cooling step, the temperature of the heater 3 was lowered to 470°C. Argon gas was furnished to the remote plasma discharge chamber 16 at 3 slm from the duct 22 to set the pressure in the reaction chamber 2 at 1-1.5 Torr by opening the valve 15. After a radiofrequency discharge at 400 kHz was generated in the remote plasma discharge chamber 16, the flow of argon was gradually reduced to 2 slm, and a gradually increasing amount of NF₃ gas was injected from the duct 22 till it reached 1 slm. When NF₃ gas introduced from the duct 22 reached the remote plasma discharge chamber 16, a fluorine active species was generated. The fluorine active species generated in the remote plasma discharge chamber 16 was, with other gas, introduced into the reaction chamber 2 from the showerhead 4 via the valve 15, duct 14 and aperture 32. The unwanted deposits adhering to the inside of the reaction chamber 2 were cleaned by the fluorine active species.

The cleaning step by the fluorine active species corresponded to the aforementioned cleaning step, and it lasted approximately 70 seconds. After the cleaning of the reaction chamber 2 was complete, radiofrequency discharge in the remote plasma discharge chamber 16 and the supply of NF₃ were both suspended. The supply of argon gas from the duct 22 was then stopped, the valve 15 was closed, and nitrogen gas was provided from the duct 5. Upon this step, the heating step was conducted, raising the temperature up to 600°C.

Conducting the silicon nitride film formation and processing in sets of 25 consecutive semiconductor substrates and then conducting the automatic cleaning sequence once, the silicon nitride film formation and processing of 2,000 semiconductor substrates was conducted.

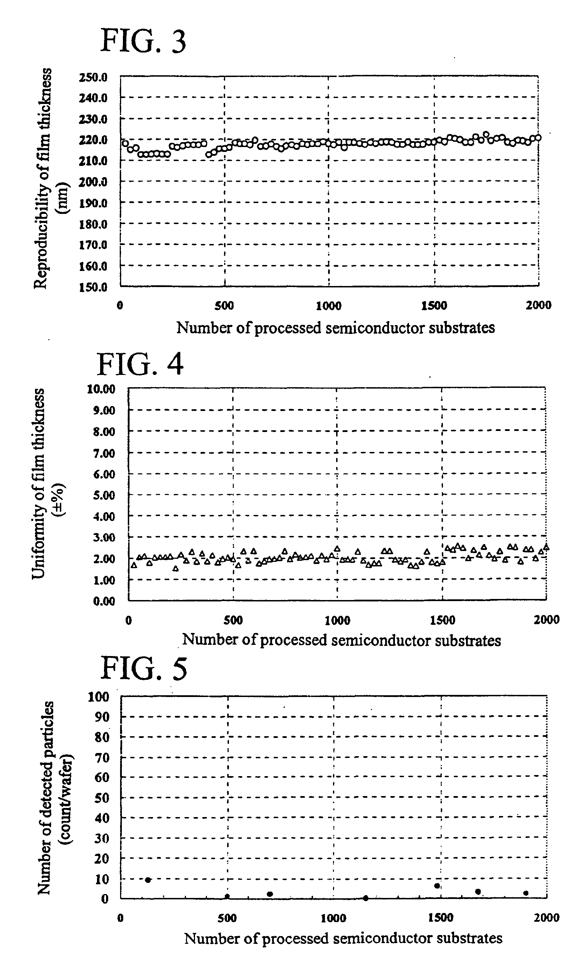

FIG. 3 illustrates the measurement results of the thickness of formed silicon nitride films (reproducibility of film thickness). Dispersion of the thickness of grown silicon nitride films (reproducibility of film thickness) is ±2.1 % (1σ=0.92 %), which is a good result.

FIG. 4 illustrates the distribution lines of the thickness of formed silicon nitride films on one semiconductor substrate 9 (uniformity of film thickness). The distribution lines of the thickness are ±2.0 % on the average for the 2,000 consecutively formed films, which are good and stable.

FIG. 5 illustrates the measurement results of particles on the surface of semiconductor substrates after the formation of silicon nitride films. The highest detected number of particles is 9 and the average value per semiconductor substrate is 3.3, which shows that the surface of semiconductor substrates is very clean.

### Other Aspects and Effects

The present invention is directed to an automatic cleaning method and apparatus therefor that can clean the unwanted deposits adhering to the inside of a semiconductor substrate process apparatus, and is not limited to a film-forming method which forms films on semiconductor substrates. According to the plasma CVD method, an explanation is made based on the formation of silicon nitride films. However, the invention is not restricted to the formation of silicon nitride films, and may be used for the formation of inorganic films of SiO, SiON and SiOF, organic films of fluorination hydrocarbon polymer, and CVD films; methylsilane, tetrametylsilane, SiO, or SiC films.

Moreover, it is clear that an automatic cleaning method in accordance with the invention may be applied to a thermal CVD method which forms a high permitivity film such as a W type metallic thin film or Ta205, and may effectively be used to clean the inside of the thin film-forming and processing apparatus.

When cleaning unwanted deposits adhering to the inside of the reaction chamber, since the surface temperature of the heater supporting the semiconductor substrate is, in an embodiment, lowered below 500°C, the adherence of aluminum fluoride to the shower head surface can be prevented. Since there is no adherence of aluminum fluoride to the showerhead surface, thin-film forming and processing of the semiconductor substrate can be performed with constant quality of the films formed.

Since aluminum fluoride is not accreted to the shower head surface in an embodiment, particles are not generated from the accreted aluminum fluoride, and the semiconductor substrate can be free of contaminants. Since the unwanted deposits adhering to the inside of the reaction chamber can be removed by automatic cleaning sequence, no particle contamination may be generated on the semiconductor. In addition, since aluminum fluoride is not generated, in-operation time of the cleaning apparatus can be reduced, which can provide a thin-film formation apparatus with high productivity.

It will be understood by those of skill in the art that numerous and various modifications can be made without departing from the spirit of the present invention. Therefore, it should be clearly understood that the forms of the present invention are illustrative only and are not intended to limit the scope of the present invention.

## Claims

1. A thin-film forming apparatus comprising:
a reaction chamber for forming a thin film on a workpiece placed on a susceptor provided in the reaction chamber, said susceptor being provided with a heater for heating the workpiece, said reaction chamber being provided with a conveyer for loading and unloading the workpiece into and from the reaction chamber; and
a cleaning device for cleaning unwanted deposits adhering to the inside of the reaction chamber at predetermined intervals, said cleaning device comprising:
(i) a cleaning gas controller for introducing a cleaning gas into the reaction chamber and evacuating the reaction chamber after the cleaning treatment;
(ii) a cleaning gas activator for activating the cleaning gas in radical form; and
(iii) a temperature and timing controller programmed to reduce the temperature of the susceptor at a predetermined rate for cleaning after completion of film formation and then to actuate the cleaning gas controller and the cleaning gas activator.

2. The apparatus according to Claim 1, wherein the temperature of the susceptor for cleaning is 500°C or less.

3. The apparatus according to Claim 1, wherein the temperature of the susceptor of cleaning is 470°C or less.

4. The apparatus according to Claim 1, wherein the temperature of the susceptor for film formation is higher than 500°C.

5. The apparatus according to Claim 1, wherein the cleaning gas includes fluorine, and the activated cleaning gas includes fluorine radicals.

6. The apparatus according to Claim 1, wherein the cleaning gas activator generates a plasma discharge region for activating the cleaning gas in the reaction chamber.

7. The apparatus according to Claim 1, wherein the cleaning gas activator comprises a remote plasma discharge chamber for activating the cleaning gas prior to introduction of the cleaning gas into the reaction chamber, said remote plasma discharge chamber being disposed separately from the reaction chamber.

8. The apparatus according to Claim 1, wherein the unwanted deposits include at least one of silicon nitride, silicon oxide, SiOF, SiC, SiON, or hydrocarbon.

9. The apparatus according to Claim 1, which is a plasma CVD apparatus or a thermal CVD apparatus.

10. The apparatus according to Claim 1, wherein the cleaning gas controller introduces the cleaning gas through a showerhead disposed above the susceptor in the reaction chamber.

11. A method for cleaning unwanted deposits adhering to the inside of a reaction chamber for forming a thin film on a workpiece placed on a susceptor provided in the reaction chamber, said susceptor being provided with a heater for heating the workpiece, said reaction chamber being provided with a conveyer for loading and unloading the workpiece into and from the reaction chamber, said method comprising:
reducing the temperature of the susceptor at a predetermined rate for cleaning after completion of film formation;
contacting the inside of the reaction chamber with an activated cleaning gas; and
cleaning the unwanted deposits by the activated cleaning gas.

12. The method according to Claim 11, wherein the cleaning is conducted at a temperature of the susceptor of 500°C or less.

13. The method according to Claim 11, wherein the cleaning is conducted at a temperature of the susceptor of 470°C or less.

14. The method according to Claim 11, wherein the temperature of the susceptor is reduced from a temperature higher than 500°C upon completion of the film formation.

15. The method according to Claim 11, wherein the cleaning gas includes fluorine, and the activated cleaning gas includes fluorine radicals.

16. The method according to Claim 11, wherein the cleaning gas is activated in a plasma discharge region generated in the reaction chamber.

17. The method according to Claim 11, wherein the cleaning gas is activated in a remote plasma discharge chamber prior to introduction of the cleaning gas into the reaction chamber, said remote plasma discharge chamber being disposed separately from the reaction chamber.

18. The method according to Claim 11, wherein the unwanted deposits include at least one of silicon nitride, silicon oxide, SiOF, SiC, SiON, or hydrocarbon.

19. The method according to Claim 11, wherein the reaction chamber is for plasma CVD or thermal CVD.

20. The method according to Claim 11, wherein the cleaning gas is introduced through a showerhead disposed above the susceptor in the reaction chamber.
